# EUROPEAN PATENT APPLICATION

(11) **EP 4 716 410 A1**
(43) Date of publication of application: **25.03.2026**
(21) Application number: 25193503.7
(22) Date of filing: 01.08.2025
(51) Int. Cl.: H10D 84/01, H10D 84/03, H10D 84/83

(54) **INTEGRATED GATE-ALL-AROUND (GAA)/FINFET TRANSISTOR DEVICES**

(30) Priority: 23.09.2024 US 202418893950
(71) Applicant: INTEL Corporation, Santa Clara, CA 95054 (US)
(72) Inventor: Lee, Chen-Guan, Portland OR, 97229 (US); Chang, Hsu-Yu, 426017 Taichung City (TW); Ramaswamy, Rahul, Portland OR, 97229 (US); Jan, Chia-Hong, Portland OR, 97229 (US)
(74) Representative: Samson & Partner Patentanwälte mbB

(57) **Abstract**

In embodiments of the present disclosure, an integrated transistor device includes a gate-all-around (GAA) transistor and a FinFET transistor device on the same substrate. The FinFET transistor includes a dielectric region between the channel of the FinFET transistor and the substrate.

## Description

### BACKGROUND

The fabrication of high-voltage transistors with a thick gate oxide may be challenging with gate all-around (GAA) architectures, e.g., ribbon field effect transistor (FET) architectures, due to small ribbon-to-ribbon spacing in the GAA transistors. This small ribbon-to-ribbon spacing is helpful for reducing gate-to-contact capacitance; however, this also causes difficulties with depositing thick gate oxides (e.g., without pinching issues).

### BRIEF DESCRIPTION OF THE DRAWINGS

FIGS. 1A-1D are perspective views of example planar, FinFET, gate-all-around (GAA), and stacked gate-all-around transistors.
FIGS. 2A-2D illustrate cross-sectional views of an example integrated gate-all-around (GAA)/FinFET device of the present disclosure.
FIGS. 3A-3I illustrate an example manufacturing process for an integrated GAA/FinFET device of the present disclosure.
FIGS. 4A-4C illustrate additional cross-sections of the device assembly as shown in FIG. 3E.
FIGS. 5A-5C illustrate additional cross-sections of the device assembly as shown in FIG. 3F.
FIGS. 6A-6C illustrate additional cross-sections of the device assembly as shown in FIG. 3G.
FIGS. 7A-7C illustrate additional cross-sections of the device assembly as shown in FIG. 3H.
FIGS. 8A-8C illustrate additional cross-sections of the device assembly as shown in FIG. 3I.
FIG. 9 is a top view of a wafer and dies that may include embodiments disclosed herein.
FIG. 10 is a cross-sectional side view of an integrated circuit device that may include embodiments herein.
FIG. 11 is a cross-sectional side view of an integrated circuit device assembly that may include embodiments disclosed herein.
FIG. 12 is a block diagram of an example electrical device that may include embodiments disclosed herein.

### DETAILED DESCRIPTION

Embodiments herein relate to integrated gate-all-around (GAA)/FinFET devices and processes for manufacturing the same. In particular, embodiments herein provide a solution for integrating high-voltage FinFET transistors into a GAA (e.g., ribbon FET) architecture to take advantage of both types of transistor architectures. Some embodiments, for example, may include a fully-isolated high-voltage FinFET transistor integrated with a GAA transistor in the same integrated circuit device. The techniques herein also do not restrict deposition of thick gate oxides for the high-voltage FinFET transistor (due to the small ribbon-to-ribbon spacing) as in previous approaches. Further, embodiments herein allow for the high-voltage FinFET transistors to take advantage of the GAA architecture to achieve full body isolation of its channel region.

In previous approaches, to make room for the thick-gate oxide of the high-voltage transistor, the ribbon-to-ribbon spacing had to be increased as well for logic or other transistors. The main drawback of this approach is that the increase in ribbon-to-ribbon spacing can cause increased capacitance, as well as degradation of the overall performance of the other transistors.

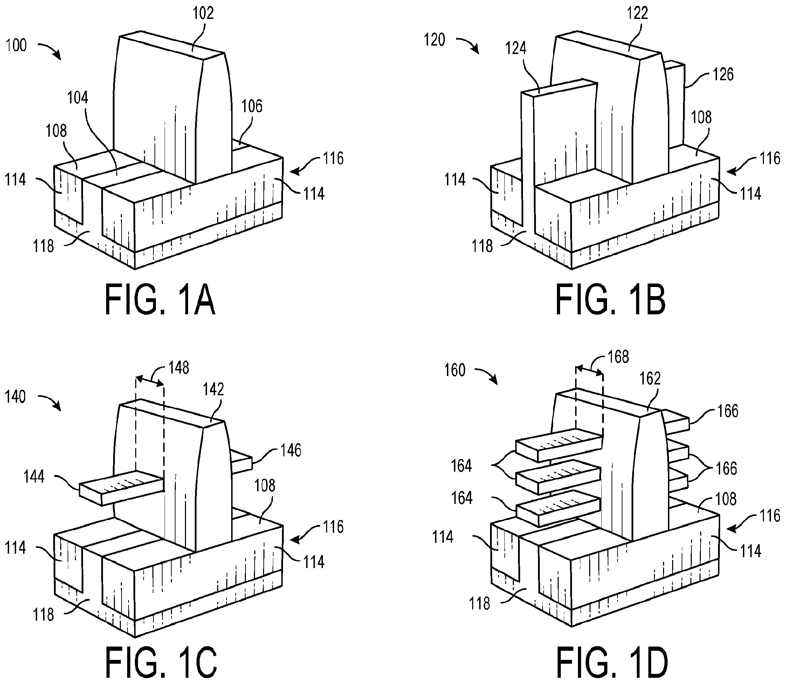

FIGS. 1A-1D are simplified perspective views of example planar, FinFET, gate-all-around, and stacked gate-all-around transistors. The transistors illustrated in FIGS. 1A-1D are formed on a substrate 116 having a surface 108. Isolation regions 114 separate the source and drain regions of the transistors from other transistors and from a bulk region 118 of the substrate 116.

FIG. 1A is a perspective view of an example planar transistor 100 comprising a gate 102 that controls current flow between a source region 104 and a drain region 106. The transistor 100 is planar in that the source region 104 and the drain region 106 are planar with respect to the substrate surface 108.

FIG. 1B is a perspective view of an example FinFET transistor 120 comprising a gate region 122 that controls current flow between a source region 124 and a drain region 126 (through a channel region inside the gate region 122). The transistor 120 is non-planar in that the source region 124 and the drain region 126 comprise "fins" that extend upwards from the substrate surface. As the gate region 122 is formed around three sides of the semiconductor fin that extends from the source region 124 to the drain region 126, the transistor 120 can be considered a tri-gate transistor. FIG. 1B illustrates one S/D fin extending through the gate region 122, but multiple S/D fins can extend through the gate of a FinFET transistor.

FIG. 1C is a perspective view of a gate-all-around (GAA) transistor 140 comprising a gate region 142 that controls current flow between a source region 144 and a drain region 146 (through a channel region inside the gate region 142). The transistor 140 is non-planar in that the source region 144 and the drain region 146 are elevated from the substrate surface.

FIG. 1D is a perspective view of a GAA transistor 160 comprising a gate region 162 that controls current flow between multiple elevated source regions 164 and multiple elevated drain regions 166 (through respective channel regions inside the gate region 162). The transistor 160 is a stacked GAA transistor as the gate controls the flow of current between multiple elevated S/D regions stacked on top of each other.

The transistors 140 and 160 are each considered gate-all-around transistors as the gates encompass all sides of the semiconductor portions that extends from the source regions to the drain regions, forming the transistor channels. The transistors 140 and 160 can alternatively be referred to as nanowire, nanosheet, or nanoribbon transistors depending on the width (e.g., widths 148 and 168 of transistors 140 and 160, respectively) or shape of the semiconductor portions extending through the gate. Although the transistor 160 includes three semiconductor portions (nanowires, nanosheets, or nanoribbons) extending through the gate region 162, other embodiments may include two or more than three semiconductor portions.

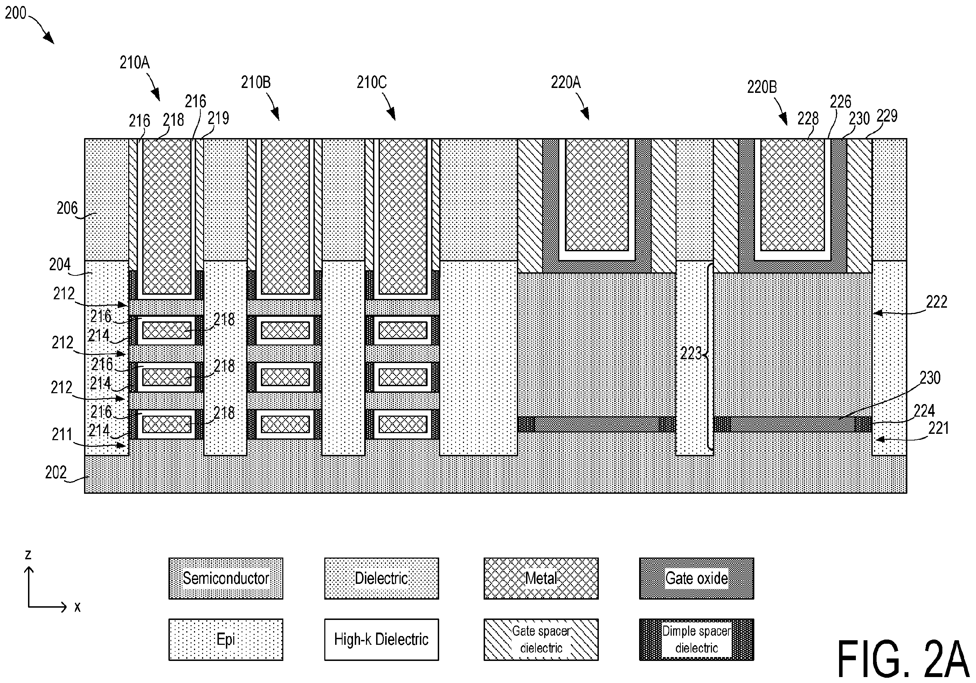

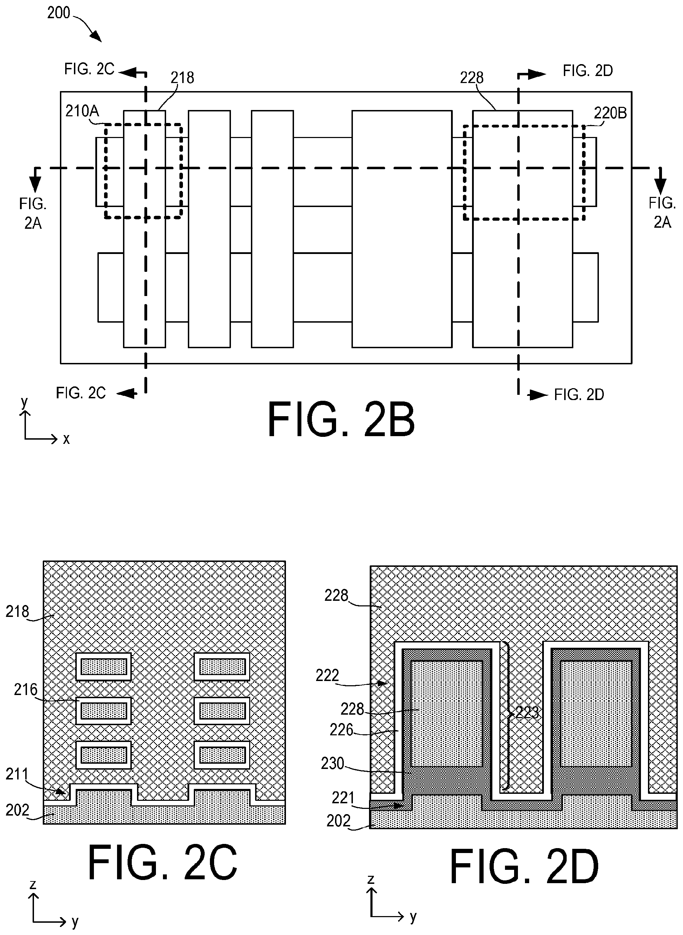

FIGS. 2A-2D illustrate cross-sectional views of an example integrated gate-all-around nd (GAA)/FinFET device 200 of the present disclosure. The device 200 includes a plurality of GAA transistors 210 and a plurality of FinFET transistors 220 as shown. Each of the transistors of the device 200 are formed on the same substrate 202, which, in the example shown, is a semiconductor material (e.g., one comprising one or more of silicon, germanium, indium antimonide, lead telluride, indium arsenide, indium phosphide, gallium arsenide, or gallium antimonide). As shown in FIGS. 2A-2D, the GAA transistors 210 are able to maintain narrow ribbon-to-ribbon spacing, while the FinFET transistors are able to include a thick gate oxide layer and also achieve full isolation of their channel regions from the substrate.

Each GAA transistor 210 includes three channel regions 212 that are formed above a sub-fin 211 that extends from the body of the substrate 202. The channel regions 212 are between (and adjacent to/in contact with) epitaxial regions 204 that may function as source/drain regions of the transistors 210. The epitaxial regions 204 are grown on the substrate 202 as shown, and may include a semiconductor material that is doped with dopants such as boron, arsenic, or phosphorous.

Each GAA transistor 210 also includes a gate region 218 that surrounds each channel region 212 as shown, with a layer of high-k dielectric 216 between the channel regions 212 and the gate region 218. The gate region 218 may include any suitable conductive material, e.g., a metal. In the example shown, each GAA transistor 210 also includes a dimple spacer dielectric 214 adjacent to the high-k dielectric 216 and between various portions of the gate region 218 and the epitaxial regions 204. The GAA transistors 210 also include a gate spacer dielectric 219 that is between the high-k dielectric 216 and the top layer of dielectric 206.

Each FinFET transistor 220 includes a fin 223 extending from the substrate 202, and the fin 223 includes a channel region 222 therein. The channel region 222 of each FinFET is between (and adjacent to/in contact with) epitaxial regions 204 that may function as source/drain regions of the transistors 220 (and may include the same or similar materials as described above).

Each FinFET transistor 220 also includes a gate region 228 that is around three sides of the fin 223 (as described above). The gate region 228 may include any suitable conductive material, e.g., a metal. Each transistor 220 also includes a layer of high-k dielectric 226 adjacent the gate region 228 and between the gate region 228 and the channel region 222. Each FinFET transistor 220 further includes a dielectric region 230 that is between the gate region 228 and the channel region 222, as well as between the channel region 222 and the sub-fin 221 extending from the body of the substrate 202. In the example shown, the dielectric region 230 of each FinFET transistor 220 surrounds the channel region 222 of the transistor 220. The FinFET transistors 220 also include a gate spacer dielectric 229 that is between a top portion of the dielectric region 230 and the top layer of dielectric 206 as shown. The dielectric region 230 may be relatively thick compared with the high-k dielectric 226, and may include silicon oxide (SiOx) or another oxide material.

As used herein, the term "region" may refer to a volume of an apparatus, device, or other object. Thus, a conductive region may refer to a volume of conducive material, and a dielectric region may refer to a volume of dielectric material. Further, as used herein, the term "surrounds" may refer to a first material (or region of a material) encompassing all sides of another, second material in at least one cross-sectional dimension, and may include one or more intermediate materials between the first and second materials. For example, as described above the gate region 218 surrounds each channel region 212 in the cross-section of FIG. 2C, but does not in the cross-section shown in FIG. 2A. Similarly, the dielectric region 230 surrounds the channel region 222 in the cross-section of FIG. 2D, but does not in the cross-section shown in FIG. 2A.

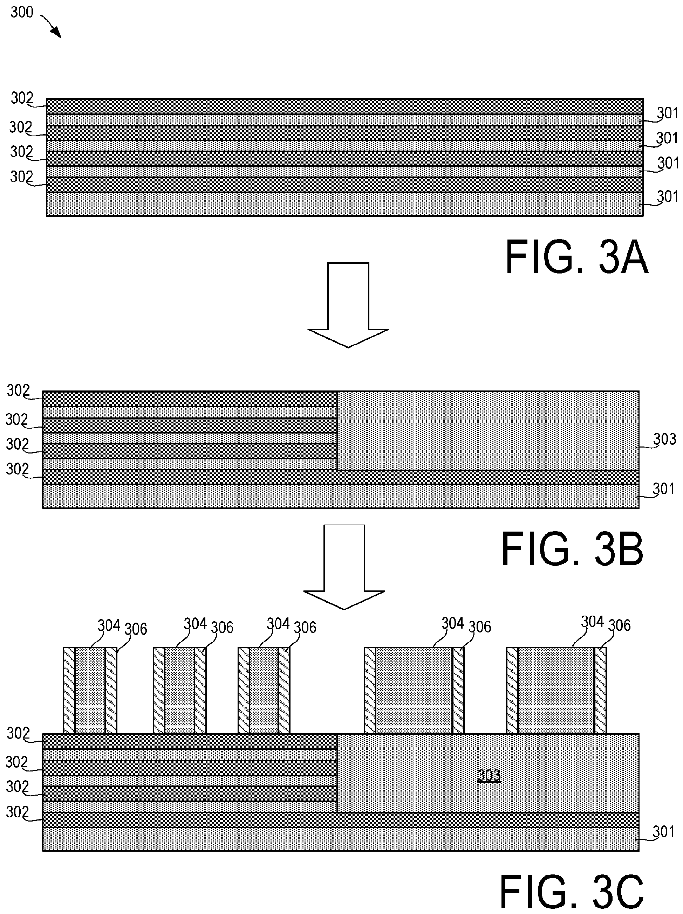

FIGS. 3A-3I illustrate an example manufacturing process 300 for an integrated GAA/FinFET device of the present disclosure. The example process 300 may include additional, fewer, or other operations than those shown.

Referring first to FIG. 3A, the process 300 begins with a superlattice stack of alternating layers of silicon (layer 301) and silicon germanium (SiGe) (layers 302). Then, a portion of the layer stack (on the right side in the example shown) is removed (e.g., etched away) and silicon is regrown in the region 303, resulting in the structure shown in FIG. 3B. It will be noted that the process of etching the stack leaves a layer 302 of SiGe under the region 303, as shown in FIG. 3B. The resulting structure can be ground and/or polished as needed.

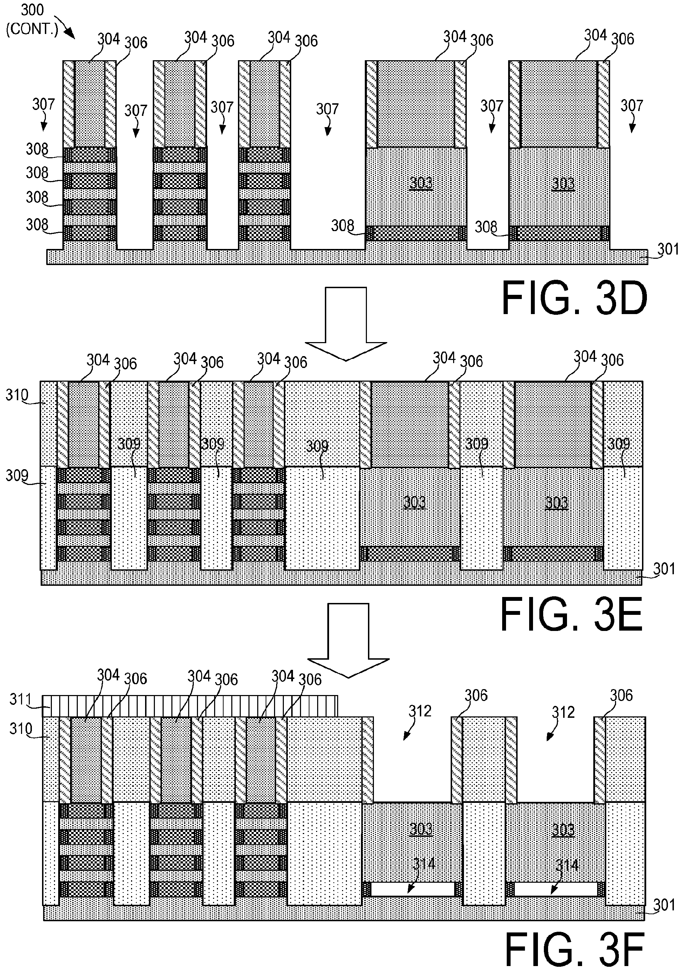

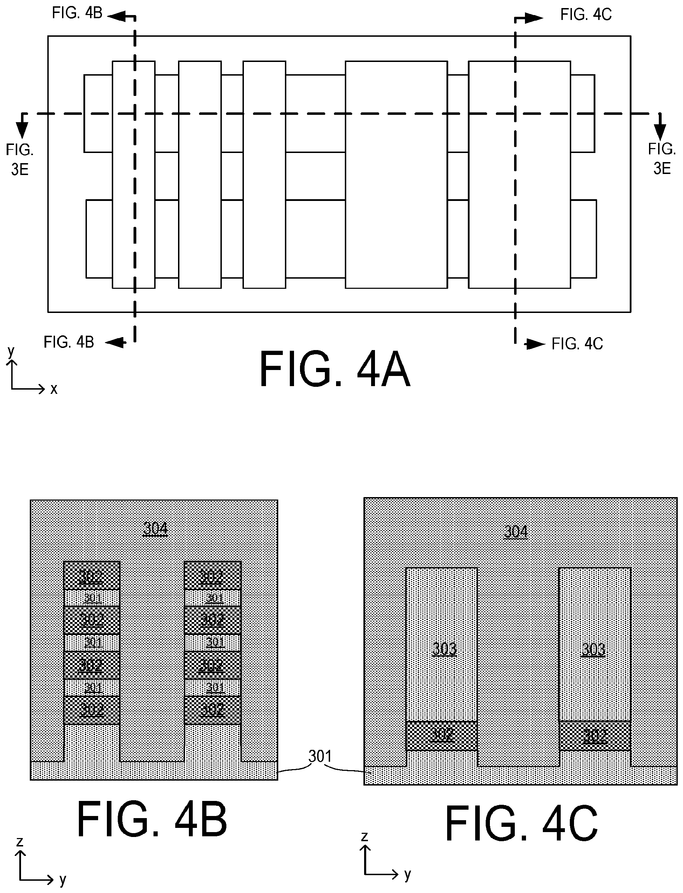

Channel processing operation can then begin. Referring to FIG. 3C, dummy gate regions 304 are formed on the structure of FIG. 3B in the area where the transistors are to be formed, with gate spacer dielectric regions 306 formed adjacent to the dummy gate regions 304. In the example shown, the left side will include GAA transistors and the right side will include FinFET transistors. Then, the structure can be etched in the regions 307, and dimple spacer dielectric 308 can be formed in the etched away portions of the remaining SiGe layers to form the transistor structures as shown in FIG. 3D. Then, epitaxial regions 309 can be grown on the substrate (the bottom layer 301 of silicon) on the sides of the transistor structures and a dielectric layer 310 can be formed above the epitaxial regions 309 as shown in FIG. 3E. FIGS. 4A-4C illustrate additional cross-sections of the device assembly as shown in FIG. 3E.

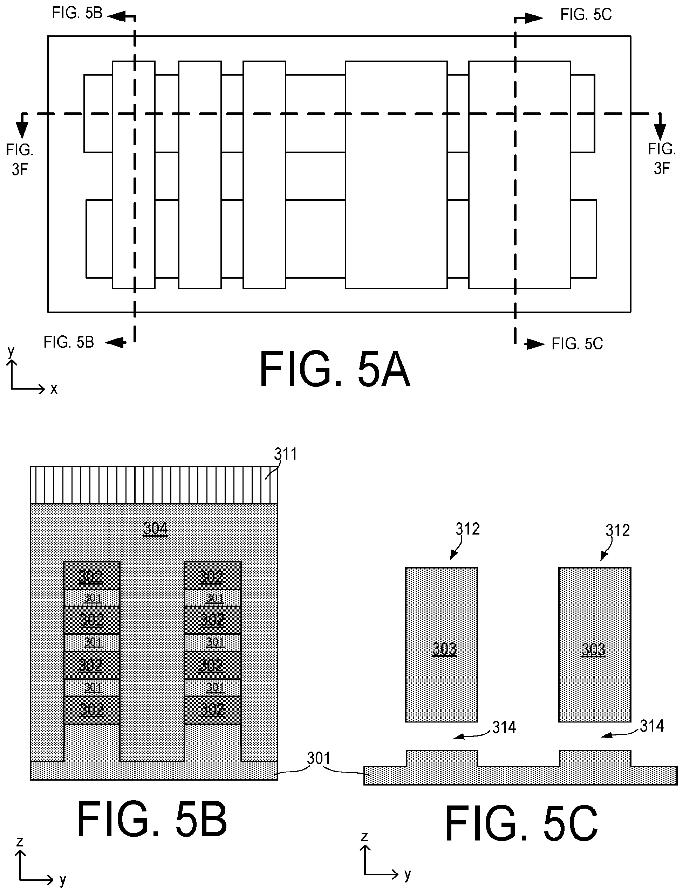

Next, the GAA side of the structure can be masked (using mask layer 311) and the dummy gate regions (in 312) of the FinFET transistor structures can be etched as shown in FIG. 3F. This etching process will also remove bottom SiGe portions of the FinFET transistors (regions 314) as shown. FIGS. 5A-5C illustrate additional cross-sections of the device assembly as shown in FIG. 3F.

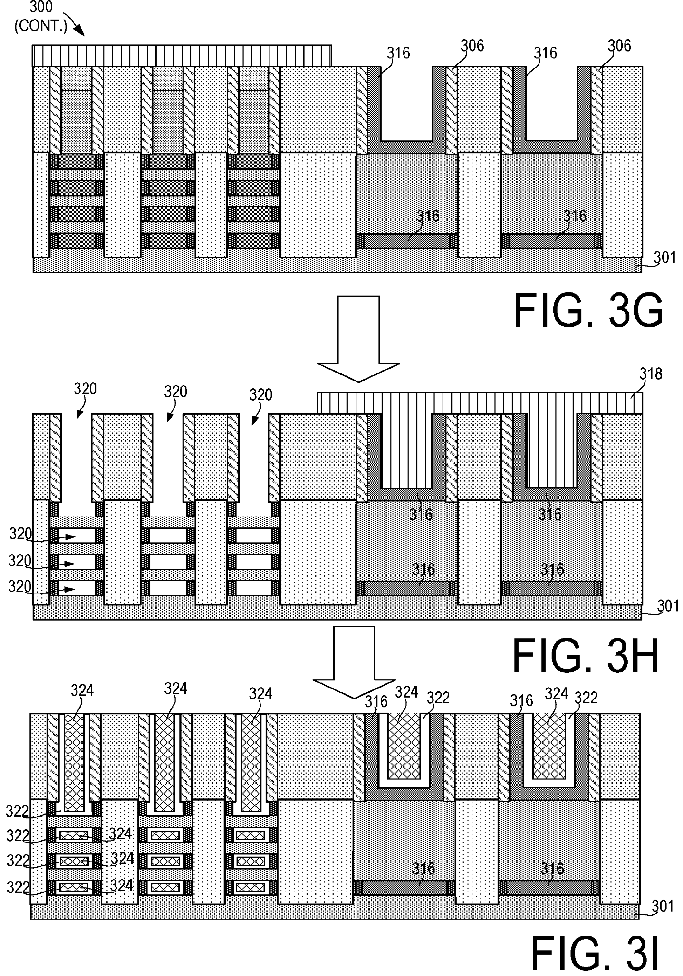

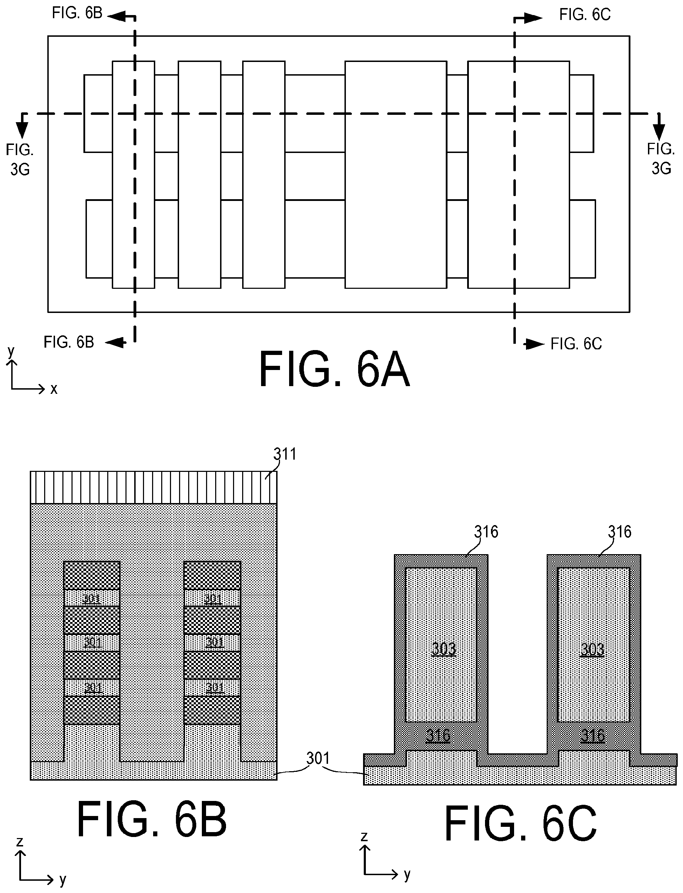

Then, a layer/region of oxide 316 can be formed as shown in FIG. 3G, in the formerly vacated regions 314 and on the inside area of the region 312 (above the channel of the FinFETs and adjacent to the gate spacer dielectric 306. FIGS. 6A-6C illustrate additional cross-sections of the device assembly as shown in FIG. 3G. This provides full isolation of the FinFET channel regions from the body (substrate) of the structure as shown.

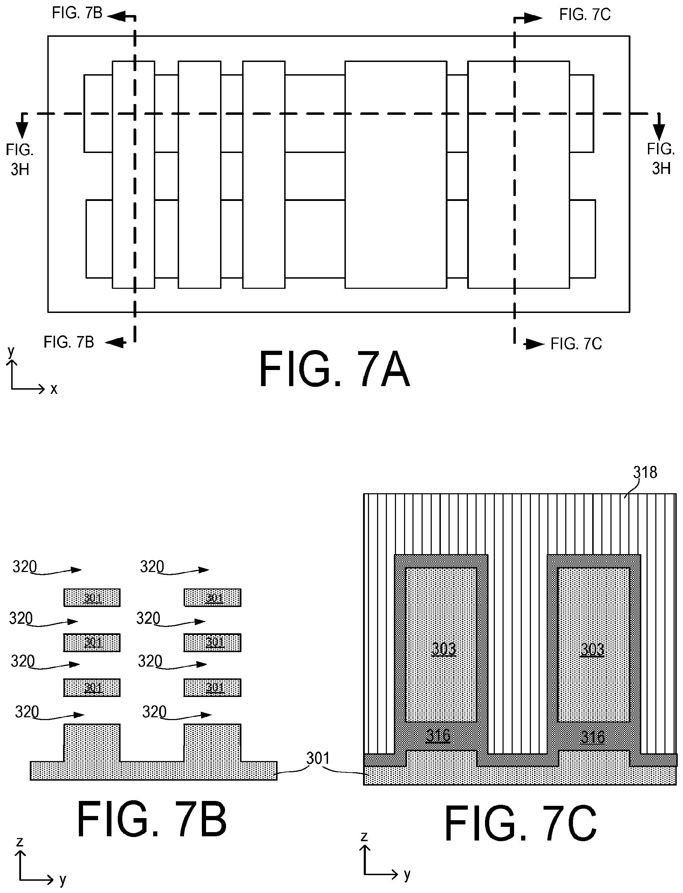

Next, the FinFET transistor area can be masked (using mask 318) and the dummy gate regions of the GAA transistors can be removed (in regions 320), resulting in the structure shown in FIG. 3H. FIGS. 7A-7C illustrate additional cross-sections of the device assembly as shown in FIG. 3H.

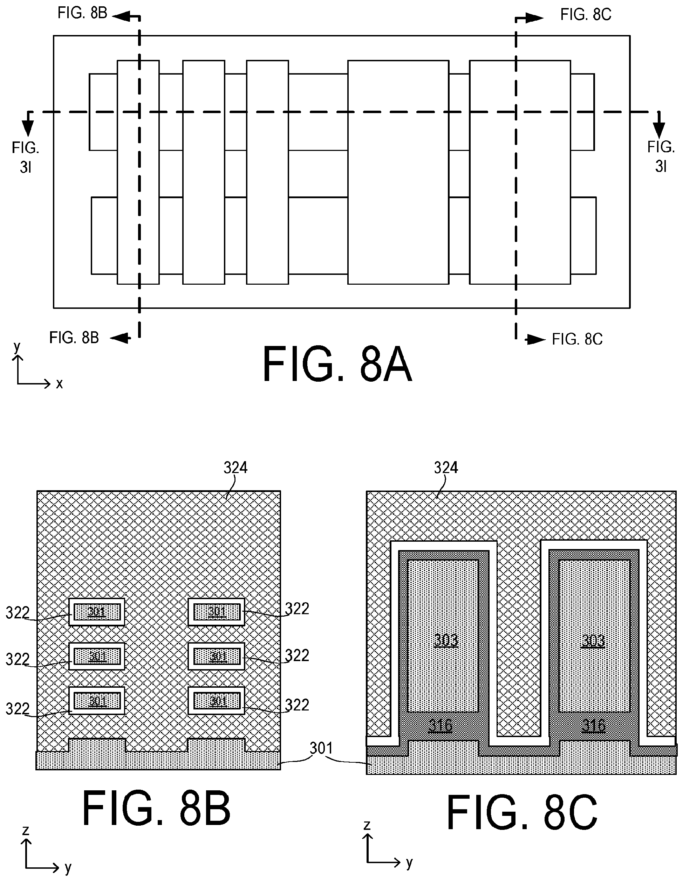

Then, as shown in FIG. 3I, the mask 318 can be removed, and a high-k dielectric layer 322 can be formed in the regions voided regions (e.g., 320). This can be followed by formation of a gate metal/conductor 324 as shown. FIGS. 8A-8C illustrate additional cross-sections of the device assembly as shown in FIG. 3I.

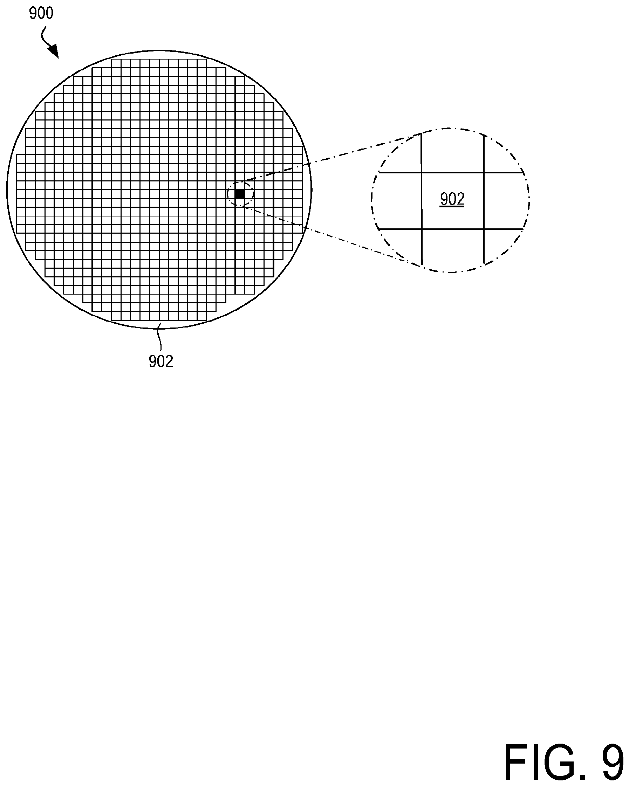

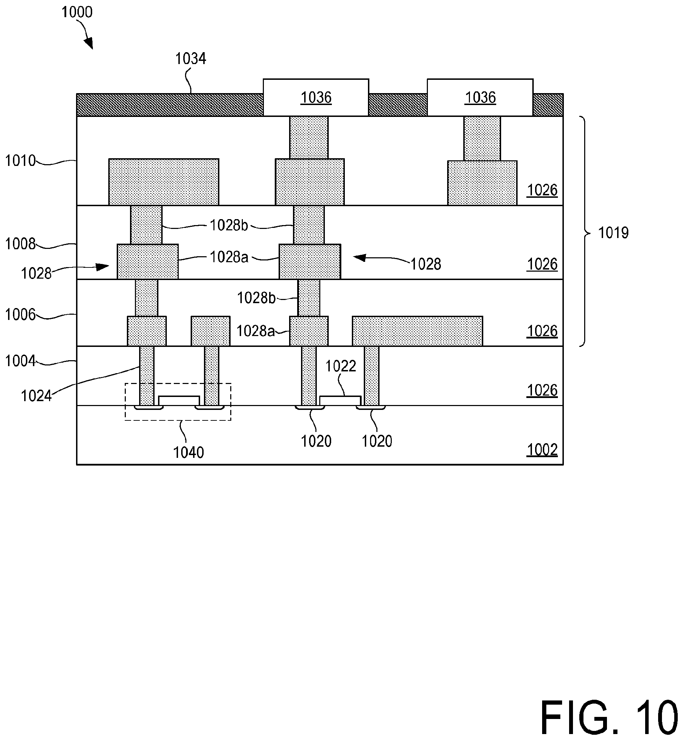

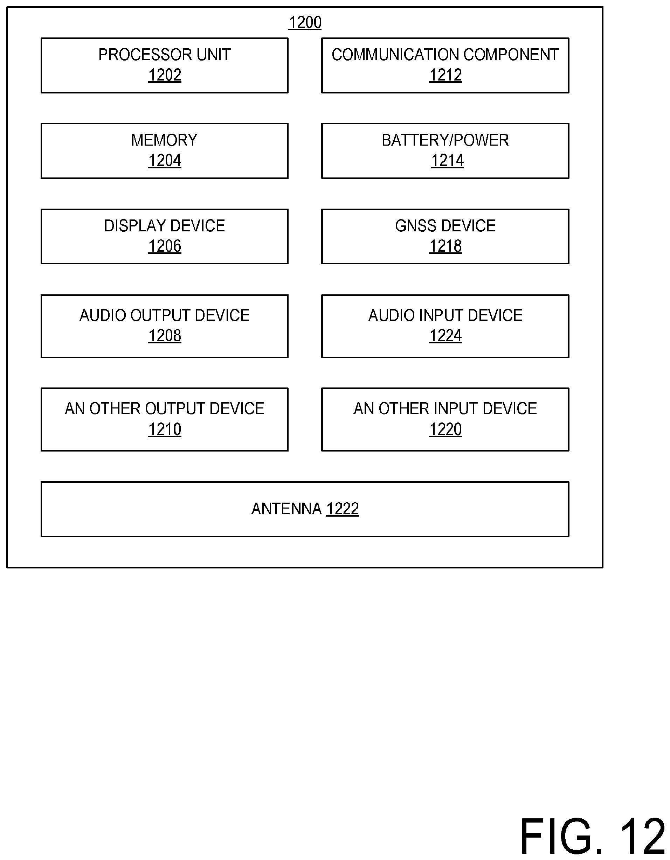

FIG. 9 is a top view of a wafer 900 and dies 902 that may incorporate any of the embodiments disclosed herein. The wafer 900 may be composed of semiconductor material and may include one or more dies 902 having integrated circuit structures formed on a surface of the wafer 900. The individual dies 902 may be a repeating unit of an integrated circuit product that includes any suitable integrated circuit. After the fabrication of the semiconductor product is complete, the wafer 900 may undergo a singulation process in which the dies 902 are separated from one another to provide discrete "chips" of the integrated circuit product. The die 902 may include one or more transistors (e.g., some of the transistors 1040 of FIG. 10, discussed below), supporting circuitry to route electrical signals to the transistors, passive components (e.g., signal traces, resistors, capacitors, or inductors), and/or any other integrated circuit components. In some embodiments, the wafer 900 or the die 902 may include a memory device (e.g., a random access memory (RAM) device, such as a static RAM (SRAM) device, a magnetic RAM (MRAM) device, a resistive RAM (RRAM) device, a conductive-bridging RAM (CBRAM) device, etc.), a logic device (e.g., an AND, OR, NAND, or NOR gate), or any other suitable circuit element. Multiple ones of these devices may be combined on a single die 902. For example, a memory array formed by multiple memory devices may be formed on a same die 902 as a processor unit (e.g., the processor unit 1202 of FIG. 12) or other logic that is configured to store information in the memory devices or execute instructions stored in the memory array.

FIG. 10 is a cross-sectional side view of an integrated circuit device 1000 that may be included in embodiments herein. One or more of the integrated circuit devices 1000 may be included in one or more dies 902 (FIG. 9). The integrated circuit device 1000 may be formed on a die substrate 1002 (e.g., the wafer 900 of FIG. 9) and may be included in a die (e.g., the die 902 of FIG. 9). The die substrate 1002 may be a semiconductor substrate composed of semiconductor material systems including, for example, n-type or p-type materials systems (or a combination of both). The die substrate 1002 may include, for example, a crystalline substrate formed using a bulk silicon or a silicon-on-insulator (SOI) substructure. In some embodiments, the die substrate 1002 may be formed using alternative materials, which may or may not be combined with silicon, that include, but are not limited to, germanium, indium antimonide, lead telluride, indium arsenide, indium phosphide, gallium arsenide, or gallium antimonide. Further materials classified as group II-VI, III-V, or IV may also be used to form the die substrate 1002. Although a few examples of materials from which the die substrate 1002 may be formed are described here, any material that may serve as a foundation for an integrated circuit device 1000 may be used. The die substrate 1002 may be part of a singulated die (e.g., the dies 902 of FIG. 9) or a wafer (e.g., the wafer 900 of FIG. 9).

The integrated circuit device 1000 may include one or more device layers 1004 disposed on the die substrate 1002. The device layer 1004 may include features of one or more transistors 1040 (e.g., FeFETs as described herein) formed on the die substrate 1002. The transistors 1040 may include, for example, one or more source and/or drain (S/D) regions 1020, a gate 1022 to control current flow between the S/D regions 1020, and one or more S/D contacts 1024 to route electrical signals to/from the S/D regions 1020. The transistors 1040 may include additional features not depicted for the sake of clarity, such as device isolation regions, gate contacts, and the like. The transistors 1040 are not limited to the type and configuration depicted in FIG. 10 and may include a wide variety of other types and configurations such as, for example, planar transistors, non-planar transistors, or a combination of both. Non- planar transistors may include FinFET transistors, such as double-gate transistors or tri-gate transistors, and wrap-around or all-around gate transistors, such as nanoribbon, nanosheet, or nanowire transistors.

A transistor 1040 may include a gate 1022 formed of at least two layers, a gate dielectric and a gate electrode. The gate dielectric may include one layer or a stack of layers. The one or more layers may include silicon oxide, silicon dioxide, silicon carbide, and/or a high-k dielectric material. The high-k dielectric material may include elements such as hafnium, silicon, oxygen, titanium, tantalum, lanthanum, aluminum, zirconium, barium, strontium, yttrium, lead, scandium, niobium, and zinc. Examples of high-k materials that may be used in the gate dielectric include, but are not limited to, hafnium oxide, hafnium silicon oxide, lanthanum oxide, lanthanum aluminum oxide, zirconium oxide, zirconium silicon oxide, tantalum oxide, titanium oxide, barium strontium titanium oxide, barium titanium oxide, strontium titanium oxide, yttrium oxide, aluminum oxide, lead scandium tantalum oxide, and lead zinc niobate. In some embodiments, an annealing process may be carried out on the gate dielectric to improve its quality when a high-k material is used.

The gate electrode may be formed on the gate dielectric and may include at least one p-type work function metal or n-type work function metal, depending on whether the transistor 1040 is to be a p-type metal oxide semiconductor (PMOS) or an n-type metal oxide semiconductor (NMOS) transistor. In some implementations, the gate electrode may consist of a stack of two or more metal layers, where one or more metal layers are work function metal layers and at least one metal layer is a fill metal layer. Further metal layers may be included for other purposes, such as a barrier layer.

For a PMOS transistor, metals that may be used for the gate electrode include, but are not limited to, ruthenium, palladium, platinum, cobalt, nickel, conductive metal oxides (e.g., ruthenium oxide), and any of the metals discussed below with reference to an NMOS transistor (e.g., for work function tuning). For an NMOS transistor, metals that may be used for the gate electrode include, but are not limited to, hafnium, zirconium, titanium, tantalum, aluminum, alloys of these metals, carbides of these metals (e.g., hafnium carbide, zirconium carbide, titanium carbide, tantalum carbide, and aluminum carbide), and any of the metals discussed above with reference to a PMOS transistor (e.g., for work function tuning).

In some embodiments, when viewed as a cross-section of the transistor 1040 along the source-channel-drain direction, the gate electrode may consist of a U-shaped structure that includes a bottom portion substantially parallel to the surface of the die substrate 1002 and two sidewall portions that are substantially perpendicular to the top surface of the die substrate 1002. In other embodiments, at least one of the metal layers that form the gate electrode may simply be a planar layer that is substantially parallel to the top surface of the die substrate 1002 and does not include sidewall portions substantially perpendicular to the top surface of the die substrate 1002. In other embodiments, the gate electrode may consist of a combination of U-shaped structures and planar, non-U-shaped structures. For example, the gate electrode may consist of one or more U-shaped metal layers formed atop one or more planar, non-U-shaped layers.

In some embodiments, a pair of sidewall spacers may be formed on opposing sides of the gate stack to bracket the gate stack. The sidewall spacers may be formed from materials such as silicon nitride, silicon oxide, silicon carbide, silicon nitride doped with carbon, and silicon oxynitride. Processes for forming sidewall spacers are well known in the art and generally include deposition and etching process steps. In some embodiments, a plurality of spacer pairs may be used; for instance, two pairs, three pairs, or four pairs of sidewall spacers may be formed on opposing sides of the gate stack.

The S/D regions 1020 may be formed within the die substrate 1002 adjacent to the gate 1022 of individual transistors 1040. The S/D regions 1020 may be formed using an implantation/diffusion process or an etching/deposition process, for example. In the former process, dopants such as boron, aluminum, antimony, phosphorous, or arsenic may be ion-implanted into the die substrate 1002 to form the S/D regions 1020. An annealing process that activates the dopants and causes them to diffuse farther into the die substrate 1002 may follow the ion-implantation process. In the latter process, the die substrate 1002 may first be etched to form recesses at the locations of the S/D regions 1020. An epitaxial deposition process may then be carried out to fill the recesses with material that is used to fabricate the S/D regions 1020. In some implementations, the S/D regions 1020 may be fabricated using a silicon alloy such as silicon germanium or silicon carbide. In some embodiments, the epitaxially deposited silicon alloy may be doped in situ with dopants such as boron, arsenic, or phosphorous. In some embodiments, the S/D regions 1020 may be formed using one or more alternate semiconductor materials such as germanium or a group III-V material or alloy. In further embodiments, one or more layers of metal and/or metal alloys may be used to form the S/D regions 1020.

Electrical signals, such as power and/or input/output (I/O) signals, may be routed to and/or from the devices (e.g., transistors 1040) of the device layer 1004 through one or more interconnect layers disposed on the device layer 1004 (illustrated in FIG. 10 as interconnect layers 1006-1010). For example, electrically conductive features of the device layer 1004 (e.g., the gate 1022 and the S/D contacts 1024) may be electrically coupled with the interconnect structures 1028 of the interconnect layers 1006-1010. The one or more interconnect layers 1006-1010 may form a metallization stack (also referred to as an "ILD stack") 1019 of the integrated circuit device 1000.

The interconnect structures 1028 may be arranged within the interconnect layers 1006-1010 to route electrical signals according to a wide variety of designs; in particular, the arrangement is not limited to the particular configuration of interconnect structures 1028 depicted in FIG. 10. Although a particular number of interconnect layers 1006-1010 is depicted in FIG. 10, embodiments of the present disclosure include integrated circuit devices having more or fewer interconnect layers than depicted.

In some embodiments, the interconnect structures 1028 may include lines 1028a and/or vias 1028b filled with an electrically conductive material such as a metal. The lines 1028a may be arranged to route electrical signals in a direction of a plane that is substantially parallel with a surface of the die substrate 1002 upon which the device layer 1004 is formed. For example, the lines 1028a may route electrical signals in a direction in and out of the page and/or in a direction across the page from the perspective of FIG. 10. The vias 1028b may be arranged to route electrical signals in a direction of a plane that is substantially perpendicular to the surface of the die substrate 1002 upon which the device layer 1004 is formed. In some embodiments, the vias 1028b may electrically couple lines 1028a of different interconnect layers 1006-1010 together.

The interconnect layers 1006-1010 may include a dielectric material 1026 disposed between the interconnect structures 1028, as shown in FIG. 10. In some embodiments, dielectric material 1026 disposed between the interconnect structures 1028 in different ones of the interconnect layers 1006-1010 may have different compositions; in other embodiments, the composition of the dielectric material 1026 between different interconnect layers 1006-1010 may be the same. The device layer 1004 may include a dielectric material 1026 disposed between the transistors 1040 and a bottom layer of the metallization stack as well. The dielectric material 1026 included in the device layer 1004 may have a different composition than the dielectric material 1026 included in the interconnect layers 1006-1010; in other embodiments, the composition of the dielectric material 1026 in the device layer 1004 may be the same as a dielectric material 1026 included in any one of the interconnect layers 1006-1010.

A first interconnect layer 1006 (referred to as Metal 1 or "M1") may be formed directly on the device layer 1004. In some embodiments, the first interconnect layer 1006 may include lines 1028a and/or vias 1028b, as shown. The lines 1028a of the first interconnect layer 1006 may be coupled with contacts (e.g., the S/D contacts 1024) of the device layer 1004. The vias 1028b of the first interconnect layer 1006 may be coupled with the lines 1028a of a second interconnect layer 1008.

The second interconnect layer 1008 (referred to as Metal 2 or "M2") may be formed directly on the first interconnect layer 1006. In some embodiments, the second interconnect layer 1008 may include via 1028b to couple the lines 1028a of the second interconnect layer 1008 with the lines 1028a of a third interconnect layer 1010. Although the lines 1028a and the vias 1028b are structurally delineated with a line within individual interconnect layers for the sake of clarity, the lines 1028a and the vias 1028b may be structurally and/or materially contiguous (e.g., simultaneously filled during a dual-damascene process) in some embodiments.

The third interconnect layer 1010 (referred to as Metal 3 or "M3") (and additional interconnect layers, as desired) may be formed in succession on the second interconnect layer 1008 according to similar techniques and configurations described in connection with the second interconnect layer 1008 or the first interconnect layer 1006. In some embodiments, the interconnect layers that are "higher up" in the metallization stack 1019 in the integrated circuit device 1000 (i.e., farther away from the device layer 1004) may be thicker that the interconnect layers that are lower in the metallization stack 1019, with lines 1028a and vias 1028b in the higher interconnect layers being thicker than those in the lower interconnect layers.

The integrated circuit device 1000 may include a solder resist material 1034 (e.g., polyimide or similar material) and one or more conductive contacts 1036 formed on the interconnect layers 1006-1010. In FIG. 10, the conductive contacts 1036 are illustrated as taking the form of bond pads. The conductive contacts 1036 may be electrically coupled with the interconnect structures 1028 and configured to route the electrical signals of the transistor(s) 1040 to external devices. For example, solder bonds may be formed on the one or more conductive contacts 1036 to mechanically and/or electrically couple an integrated circuit die including the integrated circuit device 1000 with another component (e.g., a printed circuit board). The integrated circuit device 1000 may include additional or alternate structures to route the electrical signals from the interconnect layers 1006-1010; for example, the conductive contacts 1036 may include other analogous features (e.g., posts) that route the electrical signals to external components.

In some embodiments in which the integrated circuit device 1000 is a double-sided die, the integrated circuit device 1000 may include another metallization stack (not shown) on the opposite side of the device layer(s) 1004. This metallization stack may include multiple interconnect layers as discussed above with reference to the interconnect layers 1006-1010, to provide conductive pathways (e.g., including conductive lines and vias) between the device layer(s) 1004 and additional conductive contacts (not shown) on the opposite side of the integrated circuit device 1000 from the conductive contacts 1036.

In other embodiments in which the integrated circuit device 1000 is a double-sided die, the integrated circuit device 1000 may include one or more through silicon vias (TSVs) through the die substrate 1002; these TSVs may make contact with the device layer(s) 1004, and may provide conductive pathways between the device layer(s) 1004 and additional conductive contacts (not shown) on the opposite side of the integrated circuit device 1000 from the conductive contacts 1036. In some embodiments, TSVs extending through the substrate can be used for routing power and ground signals from conductive contacts on the opposite side of the integrated circuit device 1000 from the conductive contacts 1036 to the transistors 1040 and any other components integrated into the die, and the metallization stack 1019 can be used to route I/O signals from the conductive contacts 1036 to transistors 1040 and any other components integrated into the die.

Multiple integrated circuit devices 1000 may be stacked with one or more TSVs in the individual stacked devices providing connection between one of the devices to any of the other devices in the stack. For example, one or more high-bandwidth memory (HBM) integrated circuit dies can be stacked on top of a base integrated circuit die and TSVs in the HBM dies can provide connection between the individual HBM and the base integrated circuit die. Conductive contacts can provide additional connections between adjacent integrated circuit dies in the stack. In some embodiments, the conductive contacts can be fine-pitch solder bumps (microbumps).

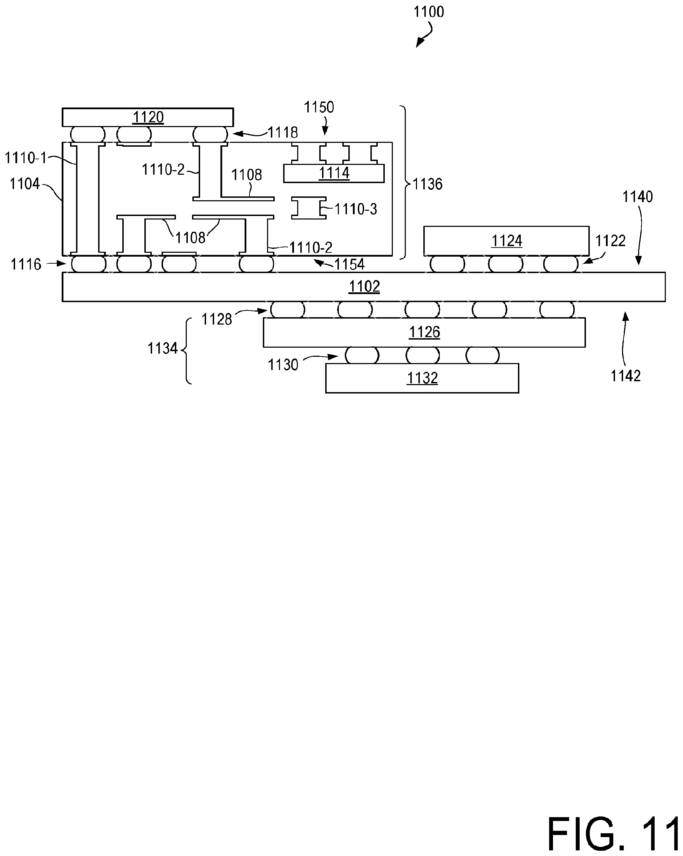

FIG. 11 is a cross-sectional side view of an integrated circuit device assembly 1100 that may include any of the embodiments disclosed herein. The integrated circuit device assembly 1100 includes a number of components disposed on a circuit board 1102 (which may be a motherboard, system board, mainboard, etc.). The integrated circuit device assembly 1100 includes components disposed on a first face 1140 of the circuit board 1102 and an opposing second face 1142 of the circuit board 1102; generally, components may be disposed on one or both faces 1140 and 1142.

In some embodiments, the circuit board 1102 may be a printed circuit board (PCB) including multiple metal (or interconnect) layers separated from one another by layers of dielectric material and interconnected by electrically conductive vias. The individual metal layers comprise conductive traces. Any one or more of the metal layers may be formed in a desired circuit pattern to route electrical signals (optionally in conjunction with other metal layers) between the components coupled to the circuit board 1102. In other embodiments, the circuit board 1102 may be a non-PCB substrate. The integrated circuit device assembly 1100 illustrated in FIG. 11 includes a package-on-interposer structure 1136 coupled to the first face 1140 of the circuit board 1102 by coupling components 1116. The coupling components 1116 may electrically and mechanically couple the package-on-interposer structure 1136 to the circuit board 1102, and may include solder balls (as shown in FIG. 11), pins (e.g., as part of a pin grid array (PGA), contacts (e.g., as part of a land grid array (LGA)), male and female portions of a socket, an adhesive, an underfill material, and/or any other suitable electrical and/or mechanical coupling structure.

The package-on-interposer structure 1136 may include an integrated circuit component 1120 coupled to an interposer 1104 by coupling components 1118. The coupling components 1118 may take any suitable form for the application, such as the forms discussed above with reference to the coupling components 1116. Although a single integrated circuit component 1120 is shown in FIG. 11, multiple integrated circuit components may be coupled to the interposer 1104; indeed, additional interposers may be coupled to the interposer 1104. The interposer 1104 may provide an intervening substrate used to bridge the circuit board 1102 and the integrated circuit component 1120.

The integrated circuit component 1120 may be a packaged or unpacked integrated circuit product that includes one or more integrated circuit dies (e.g., the die 902 of FIG. 9, the integrated circuit device 1000 of FIG. 10) and/or one or more other suitable components. A packaged integrated circuit component comprises one or more integrated circuit dies mounted on a package substrate with the integrated circuit dies and package substrate encapsulated in a casing material, such as a metal, plastic, glass, or ceramic. In one example of an unpackaged integrated circuit component 1120, a single monolithic integrated circuit die comprises solder bumps attached to contacts on the die. The solder bumps allow the die to be directly attached to the interposer 1104. The integrated circuit component 1120 can comprise one or more computing system components, such as one or more processor units (e.g., system-on-a-chip (SoC), processor core, graphics processor unit (GPU), accelerator, chipset processor), I/O controller, memory, or network interface controller. In some embodiments, the integrated circuit component 1120 can comprise one or more additional active or passive devices such as capacitors, decoupling capacitors, resistors, inductors, fuses, diodes, transformers, sensors, electrostatic discharge (ESD) devices, and memory devices.

In embodiments where the integrated circuit component 1120 comprises multiple integrated circuit dies, they dies can be of the same type (a homogeneous multi-die integrated circuit component) or of two or more different types (a heterogeneous multi-die integrated circuit component). A multi-die integrated circuit component can be referred to as a multi-chip package (MCP) or multi-chip module (MCM).

In addition to comprising one or more processor units, the integrated circuit component 1120 can comprise additional components, such as embedded DRAM, stacked high bandwidth memory (HBM), shared cache memories, input/output (I/O) controllers, or memory controllers. Any of these additional components can be located on the same integrated circuit die as a processor unit, or on one or more integrated circuit dies separate from the integrated circuit dies comprising the processor units. These separate integrated circuit dies can be referred to as "chiplets". In embodiments where an integrated circuit component comprises multiple integrated circuit dies, interconnections between dies can be provided by the package substrate, one or more silicon interposers, one or more silicon bridges embedded in the package substrate (such as Intel^{®} embedded multi-die interconnect bridges (EMIBs)), or combinations thereof.

Generally, the interposer 1104 may spread connections to a wider pitch or reroute a connection to a different connection. For example, the interposer 1104 may couple the integrated circuit component 1120 to a set of ball grid array (BGA) conductive contacts of the coupling components 1116 for coupling to the circuit board 1102. In the embodiment illustrated in FIG. 11, the integrated circuit component 1120 and the circuit board 1102 are attached to opposing sides of the interposer 1104; in other embodiments, the integrated circuit component 1120 and the circuit board 1102 may be attached to a same side of the interposer 1104. In some embodiments, three or more components may be interconnected by way of the interposer 1104.

In some embodiments, the interposer 1104 may be formed as a PCB, including multiple metal layers separated from one another by layers of dielectric material and interconnected by electrically conductive vias. In some embodiments, the interposer 1104 may be formed of an epoxy resin, a fiberglass-reinforced epoxy resin, an epoxy resin with inorganic fillers, a ceramic material, or a polymer material such as polyimide. In some embodiments, the interposer 1104 may be formed of alternate rigid or flexible materials that may include the same materials described above for use in a semiconductor substrate, such as silicon, germanium, and other group III-V and group IV materials. The interposer 1104 may include metal interconnects 1108 and vias 1110, including but not limited to through hole vias 1110-1 (that extend from a first face 1150 of the interposer 1104 to a second face 1154 of the interposer 1104), blind vias 1110-2 (that extend from the first or second faces 1150 or 1154 of the interposer 1104 to an internal metal layer), and buried vias 1110-3 (that connect internal metal layers).

In some embodiments, the interposer 1104 can comprise a silicon interposer. Through silicon vias (TSV) extending through the silicon interposer can connect connections on a first face of a silicon interposer to an opposing second face of the silicon interposer. In some embodiments, an interposer 1104 comprising a silicon interposer can further comprise one or more routing layers to route connections on a first face of the interposer 1104 to an opposing second face of the interposer 1104.

The interposer 1104 may further include embedded devices 1114, including both passive and active devices. Such devices may include, but are not limited to, capacitors, decoupling capacitors, resistors, inductors, fuses, diodes, transformers, sensors, electrostatic discharge (ESD) devices, and memory devices. More complex devices such as radio frequency devices, power amplifiers, power management devices, antennas, arrays, sensors, and microelectromechanical systems (MEMS) devices may also be formed on the interposer 1104. The package-on-interposer structure 1136 may take the form of any of the package-on-interposer structures known in the art. In embodiments where the interposer is a non-printed circuit board

The integrated circuit device assembly 1100 may include an integrated circuit component 1124 coupled to the first face 1140 of the circuit board 1102 by coupling components 1122. The coupling components 1122 may take the form of any of the embodiments discussed above with reference to the coupling components 1116, and the integrated circuit component 1124 may take the form of any of the embodiments discussed above with reference to the integrated circuit component 1120.

The integrated circuit device assembly 1100 illustrated in FIG. 11 includes a package-on-package structure 1134 coupled to the second face 1142 of the circuit board 1102 by coupling components 1128. The package-on-package structure 1134 may include an integrated circuit component 1126 and an integrated circuit component 1132 coupled together by coupling components 1130 such that the integrated circuit component 1126 is disposed between the circuit board 1102 and the integrated circuit component 1132. The coupling components 1128 and 1130 may take the form of any of the embodiments of the coupling components 1116 discussed above, and the integrated circuit components 1126 and 1132 may take the form of any of the embodiments of the integrated circuit component 1120 discussed above. The package-on-package structure 1134 may be configured in accordance with any of the package-on-package structures known in the art.

FIG. 12 is a block diagram of an example electrical device 1200 that may include one or more of the embodiments disclosed herein. For example, any suitable ones of the components of the electrical device 1200 may include one or more of the integrated circuit device assemblies 1100, integrated circuit components 1120, integrated circuit devices 1000, or integrated circuit dies 902 disclosed herein. A number of components are illustrated in FIG. 12 as included in the electrical device 1200, but any one or more of these components may be omitted or duplicated, as suitable for the application. In some embodiments, some or all of the components included in the electrical device 1200 may be attached to one or more motherboards mainboards, or system boards. In some embodiments, one or more of these components are fabricated onto a single system-on-a-chip (SoC) die.

Additionally, in various embodiments, the electrical device 1200 may not include one or more of the components illustrated in FIG. 12, but the electrical device 1200 may include interface circuitry for coupling to the one or more components. For example, the electrical device 1200 may not include a display device 1206, but may include display device interface circuitry (e.g., a connector and driver circuitry) to which a display device 1206 may be coupled. In another set of examples, the electrical device 1200 may not include an audio input device 1224 or an audio output device 1208, but may include audio input or output device interface circuitry (e.g., connectors and supporting circuitry) to which an audio input device 1224 or audio output device 1208 may be coupled.

The electrical device 1200 may include one or more processor units 1202 (e.g., one or more processor units). As used herein, the terms "processor unit", "processing unit" or "processor" may refer to any device or portion of a device that processes electronic data from registers and/or memory to transform that electronic data into other electronic data that may be stored in registers and/or memory. The processor unit 1202 may include one or more digital signal processors (DSPs), application-specific integrated circuits (ASICs), central processing units (CPUs), graphics processing units (GPUs), general-purpose GPUs (GPGPUs), accelerated processing units (APUs), field-programmable gate arrays (FPGAs), neural network processing units (NPUs), data processor units (DPUs), accelerators (e.g., graphics accelerator, compression accelerator, artificial intelligence accelerator), controller cryptoprocessors (specialized processors that execute cryptographic algorithms within hardware), server processors, controllers, or any other suitable type of processor units. As such, the processor unit can be referred to as an XPU (or xPU).

The electrical device 1200 may include a memory 1204, which may itself include one or more memory devices such as volatile memory (e.g., dynamic random access memory (DRAM), static random-access memory (SRAM)), non-volatile memory (e.g., read-only memory (ROM), flash memory, chalcogenide-based phase-change non-voltage memories), solid state memory, and/or a hard drive. In some embodiments, the memory 1204 may include memory that is located on the same integrated circuit die as the processor unit 1202. This memory may be used as cache memory (e.g., Level 1 (L1), Level 2 (L2), Level 3 (L3), Level 4 (L4), Last Level Cache (LLC)) and may include embedded dynamic random access memory (eDRAM) or spin transfer torque magnetic random access memory (STT-MRAM).

In some embodiments, the electrical device 1200 can comprise one or more processor units 1202 that are heterogeneous or asymmetric to another processor unit 1202 in the electrical device 1200. There can be a variety of differences between the processing units 1202 in a system in terms of a spectrum of metrics of merit including architectural, microarchitectural, thermal, power consumption characteristics, and the like. These differences can effectively manifest themselves as asymmetry and heterogeneity among the processor units 1202 in the electrical device 1200.

In some embodiments, the electrical device 1200 may include a communication component 1212 (e.g., one or more communication components). For example, the communication component 1212 can manage wireless communications for the transfer of data to and from the electrical device 1200. The term "wireless" and its derivatives may be used to describe circuits, devices, systems, methods, techniques, communications channels, etc., that may communicate data through the use of modulated electromagnetic radiation through a nonsolid medium. The term "wireless" does not imply that the associated devices do not contain any wires, although in some embodiments they might not.

The communication component 1212 may implement any of a number of wireless standards or protocols, including but not limited to Institute for Electrical and Electronic Engineers (IEEE) standards including Wi-Fi (IEEE 802.11 family), IEEE 802.16 standards (e.g., IEEE 802.16-2005 Amendment), Long-Term Evolution (LTE) project along with any amendments, updates, and/or revisions (e.g., advanced LTE project, ultra mobile broadband (UMB) project (also referred to as "3GPP2"), etc.). IEEE 802.16 compatible Broadband Wireless Access (BWA) networks are generally referred to as WiMAX networks, an acronym that stands for Worldwide Interoperability for Microwave Access, which is a certification mark for products that pass conformity and interoperability tests for the IEEE 802.16 standards. The communication component 1212 may operate in accordance with a Global System for Mobile Communication (GSM), General Packet Radio Service (GPRS), Universal Mobile Telecommunications System (UMTS), High Speed Packet Access (HSPA), Evolved HSPA (E-HSPA), or LTE network. The communication component 1212 may operate in accordance with Enhanced Data for GSM Evolution (EDGE), GSM EDGE Radio Access Network (GERAN), Universal Terrestrial Radio Access Network (UTRAN), or Evolved UTRAN (E-UTRAN). The communication component 1212 may operate in accordance with Code Division Multiple Access (CDMA), Time Division Multiple Access (TDMA), Digital Enhanced Cordless Telecommunications (DECT), Evolution-Data Optimized (EV-DO), and derivatives thereof, as well as any other wireless protocols that are designated as 3G, 4G, 5G, and beyond. The communication component 1212 may operate in accordance with other wireless protocols in other embodiments. The electrical device 1200 may include an antenna 1222 to facilitate wireless communications and/or to receive other wireless communications (such as AM or FM radio transmissions).

In some embodiments, the communication component 1212 may manage wired communications, such as electrical, optical, or any other suitable communication protocols (e.g., IEEE 802.3 Ethernet standards). As noted above, the communication component 1212 may include multiple communication components. For instance, a first communication component 1212 may be dedicated to shorter-range wireless communications such as Wi-Fi or Bluetooth, and a second communication component 1212 may be dedicated to longer-range wireless communications such as global positioning system (GPS), EDGE, GPRS, CDMA, WiMAX, LTE, EV-DO, or others. In some embodiments, a first communication component 1212 may be dedicated to wireless communications, and a second communication component 1212 may be dedicated to wired communications.

The electrical device 1200 may include battery/power supply circuitry 1214. The battery/power supply circuitry 1214 may include one or more energy storage devices (e.g., batteries or capacitors) and/or circuitry for coupling components of the electrical device 1200 to an energy source separate from the electrical device 1200 (e.g., AC line power).

The electrical device 1200 may include a display device 1206 (or corresponding interface circuitry, as discussed above). The display device 1206 may include one or more embedded or wired or wirelessly connected external visual indicators, such as a heads-up display, a computer monitor, a projector, a touchscreen display, a liquid crystal display (LCD), a light-emitting diode display, or a flat panel display.

The electrical device 1200 may include an audio output device 1208 (or corresponding interface circuitry, as discussed above). The audio output device 1208 may include any embedded or wired or wirelessly connected external device that generates an audible indicator, such speakers, headsets, or earbuds.

The electrical device 1200 may include an audio input device 1224 (or corresponding interface circuitry, as discussed above). The audio input device 1224 may include any embedded or wired or wirelessly connected device that generates a signal representative of a sound, such as microphones, microphone arrays, or digital instruments (e.g., instruments having a musical instrument digital interface (MIDI) output). The electrical device 1200 may include a Global Navigation Satellite System (GNSS) device 1218 (or corresponding interface circuitry, as discussed above), such as a Global Positioning System (GPS) device. The GNSS device 1218 may be in communication with a satellite-based system and may determine a geolocation of the electrical device 1200 based on information received from one or more GNSS satellites, as known in the art.

The electrical device 1200 may include another output device 1210 (or corresponding interface circuitry, as discussed above). Examples of the other output device 1210 may include an audio codec, a video codec, a printer, a wired or wireless transmitter for providing information to other devices, or an additional storage device.

The electrical device 1200 may include another input device 1220 (or corresponding interface circuitry, as discussed above). Examples of the other input device 1220 may include an accelerometer, a gyroscope, a compass, an image capture device (e.g., monoscopic or stereoscopic camera), a trackball, a trackpad, a touchpad, a keyboard, a cursor control device such as a mouse, a stylus, a touchscreen, proximity sensor, microphone, a bar code reader, a Quick Response (QR) code reader, electrocardiogram (ECG) sensor, PPG (photoplethysmogram) sensor, galvanic skin response sensor, any other sensor, or a radio frequency identification (RFID) reader.

The electrical device 1200 may have any desired form factor, such as a hand-held or mobile electrical device (e.g., a cell phone, a smart phone, a mobile internet device, a music player, a tablet computer, a laptop computer, a 2-in-1 convertible computer, a portable all-in-one computer, a netbook computer, an ultrabook computer, a personal digital assistant (PDA), an ultra mobile personal computer, a portable gaming console, etc.), a desktop electrical device, a server, a rack-level computing solution (e.g., blade, tray or sled computing systems), a workstation or other networked computing component, a printer, a scanner, a monitor, a set-top box, an entertainment control unit, a stationary gaming console, smart television, a vehicle control unit, a digital camera, a digital video recorder, a wearable electrical device or an embedded computing system (e.g., computing systems that are part of a vehicle, smart home appliance, consumer electronics product or equipment, manufacturing equipment). In some embodiments, the electrical device 1200 may be any other electronic device that processes data. In some embodiments, the electrical device 1200 may comprise multiple discrete physical components. Given the range of devices that the electrical device 1200 can be manifested as in various embodiments, in some embodiments, the electrical device 1200 can be referred to as a computing device or a computing system.

In the above description, various aspects of the illustrative implementations have been described using terms commonly employed by those skilled in the art to convey the substance of their work to others skilled in the art. However, it will be apparent to those skilled in the art that the present disclosure may be practiced with only some of the described aspects. For purposes of explanation, specific numbers, materials, and configurations have been set forth to provide a thorough understanding of the illustrative implementations. However, it will be apparent to one skilled in the art that the present disclosure may be practiced without all of the specific details. In other instances, well-known features have been omitted or simplified in order not to obscure the illustrative implementations.

Further, concepts described herein are illustrated by way of example and not by way of limitation in the accompanying figures. It will be understood that in the examples shown and described further below, the figures may not be drawn to scale and may not include all possible layers and/or circuit components. In addition, it will be understood that although certain figures illustrate transistor designs with source/drain regions, electrodes, etc. having orthogonal (e.g., perpendicular) boundaries, embodiments herein may implement such boundaries in a substantially orthogonal manner (e.g., within +/- 5 or 10 degrees of orthogonality) due to fabrication methods used to create such devices or for other reasons. Where considered appropriate, reference labels may have been repeated between certain Figures to indicate corresponding or analogous elements.

For the purposes of the present disclosure, the phrase "A and/or B" means (A), (B), or (A and B). For the purposes of the present disclosure, the phrase "A, B, and/or C" means (A), (B), (C), (A and B), (A and C), (B and C), or (A, B and C). For the purposes of the present disclosure, the phrase "A and at least one of B and C" means (A and B), (A and C), or (A and B and C).

The terms "over," "under," "between," "above," and "on" as used herein may refer to a relative position of one material layer or component with respect to other layers or components. For example, one layer disposed over or under another layer may be directly in contact with the other layer or may have one or more intervening layers. Moreover, one layer disposed between two layers may be directly in contact with the two layers or may have one or more intervening layers. In contrast, a first layer "on" a second layer is in direct contact with that second layer. Similarly, unless explicitly stated otherwise, one feature disposed between two features may be in direct contact with the adjacent features or may have one or more intervening features.

The above description may use the phrases "in an embodiment," or "in embodiments," which may each refer to one or more of the same or different embodiments. Furthermore, the terms "comprising," "including," "having," and the like, as used with respect to embodiments of the present disclosure, are synonymous.

The term "coupled with," along with its derivatives, may be used herein. "Coupled" may mean one or more of the following. "Coupled" may mean that two or more elements are in direct physical or electrical contact. However, "coupled" may also mean that two or more elements indirectly contact each other, but yet still cooperate or interact with each other, and may mean that one or more other elements are coupled or connected between the elements that are said to be coupled with each other. The term "directly coupled" may mean that two or more elements are in direct contact. The phrase "communicatively coupled" may refer to the ability of a component to send a signal to or receive a signal from another component. The signal can be any type of signal, such as an input signal, an output signal, or a power signal. A component can send or receive a signal to another component to which it is communicatively coupled via a wired or wireless communication medium (e.g., conductive traces, conductive contacts, air). Examples of components that are communicatively coupled include integrated circuit dies located in the same package that communicate via an embedded bridge in a package substrate, and an integrated circuit component attached to a printed circuit board that send signals to or receives signals from other integrated circuit components or electronic devices attached to the printed circuit board.

In various embodiments, the phrase "a first feature formed, deposited, or otherwise disposed on a second feature" may mean that the first feature is formed, deposited, or disposed over the second feature, and at least a part of the first feature may be in direct contact (e.g., direct physical and/or electrical contact) or indirect contact (e.g., having one or more other features between the first feature and the second feature) with at least a part of the second feature.

In various embodiments, the phrase "located on" in the context of a first layer or component located on a second layer or component refers to the first layer or component being directly physically attached to the second part or component (no layers or components between the first and second layers or components) or physically attached to the second layer or component with one or more intervening layers or components.

In various embodiments, the term "adjacent" refers to layers or components that are in physical contact with each other. That is, there is no layer or component between the stated adjacent layers or components. For example, a layer X that is adjacent to a layer Y refers to a layer that is in physical contact with layer Y.

Where the disclosure recites "a" or "a first" element or the equivalent thereof, such disclosure includes one or more such elements, neither requiring nor excluding two or more such elements. Further, ordinal indicators (e.g., first, second, or third) for identified elements are used to distinguish between the elements, and do not indicate or imply a required or limited number of such elements, nor do they indicate a particular position or order of such elements unless otherwise specifically stated.

Illustrative examples of the technologies described throughout this disclosure are provided below. Embodiments of these technologies may include any one or more, and any combination of, the examples described below. In some embodiments, at least one of the systems or components set forth in one or more of the preceding figures may be configured to perform one or more operations, techniques, processes, and/or methods as set forth in the following examples.

Example 1 is an apparatus comprising: a substrate; a first transistor on the substrate, the first transistor comprising: a plurality of first channel regions; and a first gate region surrounding each of the first channel regions; a second transistor on the substrate, the second transistor comprising: a second channel region; a second gate region around at least three sides of the second channel region; and a dielectric region comprising Oxygen between the second gate region and the second channel region and further between the second channel region and the substrate.

Example 2 includes the apparatus of Example 1, wherein the first channel regions are above a first sub-fin extending from the substrate and the second channel region is above a second sub-fin extending from the substrate.

Example 3 includes the apparatus of Example 1 or 2, wherein the dielectric region comprising Oxygen surrounds the second channel region.

Example 4 includes the apparatus of any one of Examples 1-3, wherein each of the substrate, the first channel regions, and the second channel region are semiconductor materials comprising Silicon.

Example 5 includes the apparatus of any one of Examples 1-4, wherein: the first transistor comprises epitaxial regions adjacent opposite sides of the first channel regions; and the second transistor comprises epitaxial regions adjacent opposite sides of the second channel region.

Example 6 includes the apparatus of Example 5, wherein each of the epitaxial regions is on the substrate.

Example 7 includes the apparatus of Examples 5 or 6, wherein the dielectric region is a first dielectric region, and the second transistor further comprises second dielectric regions between the first dielectric region and the epitaxial regions of the second transistor.

Example 8 is an integrated circuit device assembly comprising a circuit board and the apparatus of any one of Examples 1-7.

Example 9 is a system comprising the integrated circuit device assembly of Example 8 and one or more memory devices.

Example 10 is an integrated circuit device comprising: a semiconductor layer; a first transistor on the semiconductor layer, the first transistor comprising: a plurality of semiconductor channel regions above the semiconductor layer, the channel regions connecting a source region of the first transistor and a drain region of the first transistor; and a conductive gate region surrounding each of the channel regions; and a second transistor on the semiconductor layer, the second transistor comprising: a fin extending from the semiconductor layer, the fin comprising a channel region; and a conductive gate region around the fin; wherein the fin comprises a dielectric between the channel region and the semiconductor layer.

Example 11 includes the integrated circuit device of Example 10, wherein the dielectric surrounds the channel region of the second transistor.

Example 12 includes the integrated circuit device of Example 10 or 11, wherein dielectric comprises Oxygen.

Example 13 includes the integrated circuit device of any one of Examples 10-12, wherein each of the semiconductor layer, the channel regions of the first transistor, and the channel region of the second transistor are semiconductor materials comprising Silicon

Example 14 includes the integrated circuit device of any one of Examples 10-13, wherein: the first transistor comprises epitaxial regions adjacent opposite sides of its channel regions; and the second transistor comprises epitaxial regions adjacent opposite sides of its channel region; wherein each of the epitaxial regions is on the semiconductor layer.

Example 15 includes the integrated circuit device of Example 14, wherein the dielectric is a first dielectric, and the second transistor comprises a second dielectric between the first dielectric and the epitaxial regions of the second transistor.

Example 16 is an integrated circuit device comprising: a semiconductor substrate; a gate-all-around (GAA) transistor on the semiconductor substrate; and a FinFET transistor on the semiconductor substrate, the FinFET comprising a dielectric region between a gate region and a channel region of the FinFET transistor and further between the channel region and the substrate.

Example 17 includes the integrated circuit device of Example 16, wherein the dielectric region of the FinFET transistor surrounds the channel region.

Example 18 includes the integrated circuit device of Example 16 or 17, wherein the dielectric region of the FinFET transistor comprises Oxygen.

Example 19 is a processor comprising the integrated circuit device of any one of Examples 10-18.

Example 20 is a system comprising the processor of Example 19 and one or more memory devices.

## Claims

1. An apparatus comprising:
a substrate;
a first transistor on the substrate, the first transistor comprising:
a plurality of first channel regions; and
a first gate region surrounding each of the first channel regions;
a second transistor on the substrate, the second transistor comprising:
a second channel region;
a second gate region around at least three sides of the second channel region; and
a dielectric region comprising Oxygen between the second gate region and the second channel region and further between the second channel region and the substrate.

2. The apparatus of claim 1, wherein the first channel regions are above a first sub-fin extending from the substrate and the second channel region is above a second sub-fin extending from the substrate.

3. The apparatus of claim 1 or 2, wherein the dielectric region comprising Oxygen surrounds the second channel region.

4. The apparatus of any one of claims 1-3, wherein each of the substrate, the first channel regions, and the second channel region are semiconductor materials comprising Silicon.

5. The apparatus of any one of claims 1-4, wherein:
the first transistor comprises epitaxial regions adjacent opposite sides of the first channel regions; and
the second transistor comprises epitaxial regions adjacent opposite sides of the second channel region.

6. The apparatus of claim 5, wherein each of the epitaxial regions is on the substrate.

7. The apparatus of claim 5 or 6, wherein the dielectric region is a first dielectric region, and the second transistor further comprises second dielectric regions between the first dielectric region and the epitaxial regions of the second transistor.

8. An integrated circuit device assembly comprising a circuit board and the apparatus of any one of claims 1-7.

9. An integrated circuit device comprising:
a semiconductor layer;
a first transistor on the semiconductor layer, the first transistor comprising:
a plurality of semiconductor channel regions above the semiconductor layer, the channel regions connecting a source region of the first transistor and a drain region of the first transistor; and
a conductive gate region surrounding each of the channel regions; and
a second transistor on the semiconductor layer, the second transistor comprising:
a fin extending from the semiconductor layer, the fin comprising a channel region; and
a conductive gate region around the fin;
wherein the fin comprises a dielectric between the channel region and the semiconductor layer.

10. The integrated circuit device of claim 9, wherein the dielectric surrounds the channel region of the second transistor.

11. The integrated circuit device of claim 9 or 10, wherein dielectric comprises Oxygen.

12. The integrated circuit device of any one of claims 9-11, wherein each of the semiconductor layer, the channel regions of the first transistor, and the channel region of the second transistor are semiconductor materials comprising Silicon.

13. The integrated circuit device of any one of claims 9-12, wherein:
the first transistor comprises epitaxial regions adjacent opposite sides of its channel regions; and
the second transistor comprises epitaxial regions adjacent opposite sides of its channel region;
wherein each of the epitaxial regions is on the semiconductor layer.

14. The integrated circuit device of claim 13, wherein the dielectric is a first dielectric, and the second transistor comprises a second dielectric between the first dielectric and the epitaxial regions of the second transistor.

15. A processor comprising the integrated circuit device of any one of claims 9-14.
